# EUROPEAN PATENT SPECIFICATION

(11) **EP 4 431 962 B1**
(45) Date of publication and mention of the grant of the patent: **11.11.2026**
(21) Application number: 23791146.6
(22) Date of filing: 14.04.2023
(51) Int. Cl.: G01R 31/392, G01R 31/367, B60L 58/16, G06F 17/10, G06F 17/18, G01R 31/3842, G01R 31/396

(54) **METHOD AND APPARATUS FOR CALCULATING STATE OF HEALTH OF POWER SUPPLY SYSTEM**
VERFAHREN UND VORRICHTUNG ZUR BERECHNUNG DES GESUNDHEITSZUSTANDS EINES STROMVERSORGUNGSSYSTEMS
PROCÉDÉ ET APPAREIL PERMETTANT DE CALCULER L'ÉTAT DE SANTÉ D'UN SYSTÈME D'ALIMENTATION ÉLECTRIQUE

(30) Priority: 21.04.2022 CN 202210426959
(43) Date of publication of application: 18.09.2024
(73) Proprietor: Yutong Bus Co., Ltd., Zhengzhou, Henan 450061 (CN)
(72) Inventor: ZHOU, Xuesong, Zhengzhou, Henan 450061 (CN); LI, Yunxiao, Zhengzhou, Henan 450061 (CN); CHEN, Yuqing, Zhengzhou, Henan 450061 (CN); LI, Jing, Zhengzhou, Henan 450061 (CN)
(74) Representative: Gulde & Partner
(86) International application number: PCT/CN2023/088442
(87) International publication number: WO 2023/202491

(56) References cited:
- EP-A1- 3 258 282
- CN-A- 108 732 503
- CN-A- 109 557 477
- CN-A- 111 983 495
- CN-A- 112 147 513
- CN-A- 113 253 140
- CN-A- 114 035 072
- CN-A- 114 050 633
- CN-A- 114 089 207
- JP-B2- 5 832 380
- US-A1- 2004 119 441
- US-A1- 2016 003 917
- US-A1- 2018 236 890
- US-B2- 11 029 363

## Description

### TECHNICAL FIELD

The present invention relates to the field of evaluation technologies of a state of health (SOH) of a power supply, and in particular, to a method and apparatus for calculating an SOH of a power supply system.

### BACKGROUND

With the widespread popularity of new energy vehicles, some vehicles have entered the end of their lifespan. Issues such as safety, secondary utilization, and residual value assessment of batteries have also received increasing attention from the entire industry. However, accurate evaluation of battery health has always been a challenge in the industry, because a full and deep charge of each vehicle is very costly. Therefore, a data technology based on operational data is urgently needed to accurately evaluate a state of health (SOH, which is a ratio of an actual capacity of a battery to a rated capacity) of the battery.

A lithium iron phosphate (LFP) power supply system is widely used in the new energy vehicles. However, a voltage plateau exists due to material characteristics of the power supply system, and a state of charge (SOC, which is a state of availability of the residual charge of a battery system) cannot be accurately estimated during the plateau, resulting in a difficulty in calculation of the SOH. A method for calculating an SOH based on a battery model cannot be used to accurately calculate the SOH of a vehicle due to lack of dynamic consideration of real working conditions and aging.

Conventional methods are known from CN 113 253 140 A, US 2016/003917 A1, US 11 029 363 B2, US 2004/119441 A1 and JP 5 832380 B2.

### SUMMARY

The present invention is intended to provide a method, as defined in claims 1 to 8, for calculating a state of health (SOH) of a power supply system, so as to resolve a problem of inaccurate calculation of the SOH in the prior art. In addition, the present invention further provides an apparatus, as defined in claim 9, for calculating an SOH of a power supply system, and configured to implement the foregoing method for calculating an SOH of a power supply system.

To resolve the foregoing problem, the technical solutions provided in the present invention and the beneficial effects corresponding to the technical solutions are as follows.

A method for calculating an SOH of a battery of the present invention is provided, wherein the method is carried out by an apparatus comprising a processor, a memory, and an internal bus, and the method includes the following steps:
1) obtaining a plurality of pieces of charging and discharging data corresponding to the battery at different moments, where each of the pieces of charging and discharging data includes a charging/discharging moment, a displayed state of charge (SOC), a charging/discharging current, a highest cell voltage, and a lowest cell voltage, and extracting charging scene data that satisfies a requirement from the charging and discharging data, where the charging scene data includes a plurality of charging groups, and data of one charging group is data of a full charging process;
2) performing the following calculation on the charging group:
   determining a charging capacity C_{N} for current charging based on each moment and a corresponding charging current thereof;
   extracting the plurality of pieces of charging and discharging data before the charging is divided into groups if the charging current for the current charging is greater than or equal to a set charging current threshold A₁, screening the charging and discharging data for a segment of charging and discharging data whose discharging current is less than a set quiescent current threshold A₂ and that has a longest duration, and determining, based on a highest cell voltage V_{OCV high}/lowest cell voltage V_{OCV low} of a last piece of data in the segment of charging and discharging data and an SOC-open circuit voltage (OCV) relationship, a true SOC SOC_{OCV high} of a highest OCV/true SOC SOC_{OCV low} of a lowest OCV corresponding to the highest cell voltage V_{OCV high}/lowest cell voltage V_{OCV low} of the last piece of data; calculating a true SOC SOC_{high start} of a cell with a highest voltage at a start of charging during the current charging and a true SOC SOC_{low start} of a cell with a lowest voltage at the start of charging during the current charging based on the following equation: 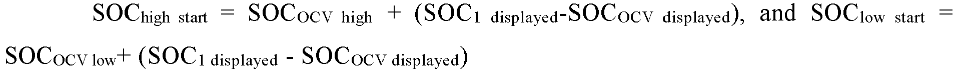 SOChigh start = SOCOCV high + (SOC1 displayed-SOCOCV displayed), and SOClow start = SOCOCV low+ (SOC1 displayed - SOCOCV displayed)
   where SOC_{OCV displayed} represents a displayed SOC SOC_{OCV displayed} of the last piece of data in the segment of charging and discharging data, and SOC_{1 displayed} represents a displayed SOC of a first piece of data of the charging group;
3) calculating an SOH SOH_{cell} of the cell with a highest voltage based on the following equation: SOH_{cell} = C_{N}/[(100%-SOC_{high start}) * C_{rated}], where C_{rated} represents a rated capacity of the cell with a highest voltage; and
4) obtaining an SOH of the battery based on the SOH SOH_{cell} of the cell with a highest voltage.

Further, in step 4), an SOH SOH_{system} of the battery is calculated based on the following equation: SOH_{system} = SOH_{cell}*k_{consistency}, where k_{consistency} represents a consistency coefficient, and k = 100% - SOC_{high start} - SOC_{low start}.

The beneficial effect of the foregoing technical solution is as follows. According to the present invention, charging group data is extracted from a large amount of charging and discharging data. The charging group data and a plurality of pieces of data before a charging is divided into groups are screened for OCV data. A true SOC corresponding to the OCV data may be determined by using the OCV data and a SOC-OCV relationship. The true SOC is obtained and then is corrected and compensated, so as to obtain a true SOC SOC_{high start} of a cell with a highest voltage at a start of charging and a true SOC SOC_{low start} of a cell with a lowest voltage at the start of charging. An SOH SOH_{cell} of the cell with a highest voltage may be calculated based on a charging capacity C_{N} for current charging. Finally, considering consistency between batteries, the SOH SOH_{system} of the power supply system is calculated.

Many factors are considered as a whole in the method. Firstly, in the method, the displayed SOC at the start of charging is not directly used as the SOC at the start of charging for subsequent calculation, but the SOC calculated by using compensated OCV data is used as the SOC at the start of charging, with the consideration of possible charging and discharging behaviors that may exist between an OCV measurement moment and a start moment of charging (a full charging process), which ensures accuracy of subsequent calculation of the SOH. Secondly, during calculation of an SOH of a battery cell, the SOH of the cell with a highest voltage is calculated. This is because the cell with a highest voltage is generally fully charged, and it is relatively easy to obtain the data and convenient for the subsequent calculation. Finally, considering consistency among a plurality of cells, a more accurate SOH of the battery is calculated.

Further, in step 2), if the charging current for the current charging is less than the set charging current threshold A₁, based on the highest cell voltage V_{highest}/lowest cell voltage V_{lowest} of the last piece of data before the charging is divided into groups and the SOC-OCV relationship, an SOC corresponding to a highest cell voltage V_{highest}/lowest cell voltage V_{lowest} of the last piece of data before the charging is divided into groups is used as the true SOC SOC_{high start} of the cell with a highest voltage/true SOC SOC_{low start} of the cell with a lowest voltage at the start of charging during the current charging.

Further, the method further includes step 5) to step 6):
5) correcting the SOC-OCV relationship by using the following equations: $SOC = A \times {e}^{B \times OCV}$ $A = A 1 \times {e}^{A 2 \times t}$ $B = B 1 \times {e}^{B 2 \times t}$
where SOC represents an SOC corresponding to an OCV, A1, A2, B1, and B2 all represent aging parameters, and t represents a usage time; and
6) re-performing step 2) to step 4) by using the corrected SOC-OCV relationship, to obtain a corrected SOH SOH_{system} of the battery.

The beneficial effect of the foregoing technical solution is as follows. Considering aging of a battery, the SOC-OCV relationship is corrected, and the SOH SOH_{system} of the battery is calculated by using the corrected SOC-OCV relationship, which ensures accuracy of calculation of the SOH.

Further, the usage time t is calculated by using the following equation: $t = \sqrt[k 1]{\left(1-SOH\right) / k 2}$
where k1 and k2 both represent usage time parameters, and the SOH represents the SOH of the battery and is the SOH of the battery obtained in step 4).

The beneficial effect of the foregoing technical solution is as follows. The usage time of the battery is represented by using the SOH of the battery, instead of subtracting a delivery time or a sales time from a current time as the usage time, is because the inaccurate time and battery replacement both cause the usage time calculated by using the latter method to be meaningless. Therefore, the method of the present invention ensures accuracy of the calculation of the usage time.

Further, the usage time parameters k1 and k2 are determined in the following manners: obtaining a plurality of sets of different usage times and different SOH data of the battery, and using the corresponding SOH data that occurs a maximum number of times at a certain usage time as an SOH corresponding to a usage time; fitting the different usage times and the corresponding SOH data to the equation $t = \sqrt[k 1]{\left(1-SOH\right) / k 2}$ to obtain the usage time parameters k1 and k2.

The beneficial effect of the foregoing technical solution is as follows. A relationship between the SOH of the battery and the usage time is determined by using big data, so that the fitted usage time parameter is more accurate, so as to more accurately reflect the relationship between the SOH of the battery and the usage time.

Further, in step 1), the requirement includes at least one of the following requirements:
requirement 1: a ratio of a number of current jumps of the current charging to a total number of current jumps of all charging groups is less than a set jump percentage threshold, where a current jump means that an absolute value of a difference between a charging current of a piece of data and a charging current of a previous piece of data of the piece of data is greater than a set current deviation threshold;
requirement 2: positions of the cell with a highest voltage and a cell with a second highest voltage are not adjacent or the lowest cell voltage is greater than a set low voltage threshold;
requirement 3: a total charging duration of one of the charging groups is greater than a set duration threshold;
requirement 4: a difference between a displayed SOC of a last piece of data of the charging group and a displayed SOC of the first piece of data is greater than a set SOC difference threshold; and
requirement 5: the displayed SOC of the last piece of data of the charging group is greater than a set SOC end threshold.

The beneficial effect of the foregoing technical solution is that the requirement 2 may eliminate a charge termination fluctuation.

Further, a means of determining the charging capacity C_{N} for the current charging in step 2) is: ① calculating a charging capacity Cₓ between adjacent moments corresponding to two adjacent pieces of data based on the two adjacent pieces of data; and ② adding the charging capacities among all of the adjacent moments to obtain the charging capacity C_{N} for the current charging. Specifically, step ① is based on the following: if a time interval △t corresponding to the two adjacent pieces of data is less than a set low adjacent time threshold, a charging capacity between the adjacent moments corresponding to the two adjacent pieces of data is the charging current multiplied by the time interval △t; if the time interval corresponding to the two adjacent pieces of data is greater than a set high adjacent time threshold and an interval SOC △SOC corresponding to the two adjacent pieces of data is less than a set SOC threshold, the charging capacity between the adjacent moments corresponding to the two adjacent pieces of data is the charging current multiplied by 10 seconds, and the set low adjacent time threshold is less than the set high adjacent time threshold; otherwise, the charging capacity between the adjacent moments corresponding to the two adjacent pieces of data is an average of charging currents corresponding to two pieces of data multiplied by the time interval △t.

The beneficial effect of the foregoing technical solution is as follows. Considering a plurality of different actual situations, the charging capacity Cₓ between the adjacent moments is calculated, which ensure accuracy of the calculation.

An apparatus for calculating an SOH of a battery of the present invention includes a memory and a processor. The processor is configured to execute an instruction stored in the memory to implement the method for calculating an SOH of a battery described above, to implement the same beneficial effect as the method.

### BRIEF DESCRIPTION OF THE DRAWINGS

FIG. 1 is a flowchart of a method for calculating a state of health (SOH) of a power supply system according to the present invention.
FIG. 2 is a schematic diagram of a distribution of errors of the SOH according to the present invention.
FIG. 3 is a diagram of data examples according to the present invention.
FIG. 4 is a graph of a state of charge (SOC)-open circuit voltage (OCV) curve graph fitted by old and new batteries according to the present invention.
FIG. 5 is a schematic diagram of a deviation distribution after SOC-OCV curve varies with years and a current deviation distribution according to the present invention.
FIG. 6 is a schematic structural diagram of an apparatus for calculating an SOH of a power supply system according to the present invention.

### DETAILED DESCRIPTION

A method for calculating a state of health (SOH) of a power supply system and an apparatus for calculating an SOH of a power supply system of the present invention are described in detail below with reference to the accompanying drawings and embodiments.

### Method embodiment:

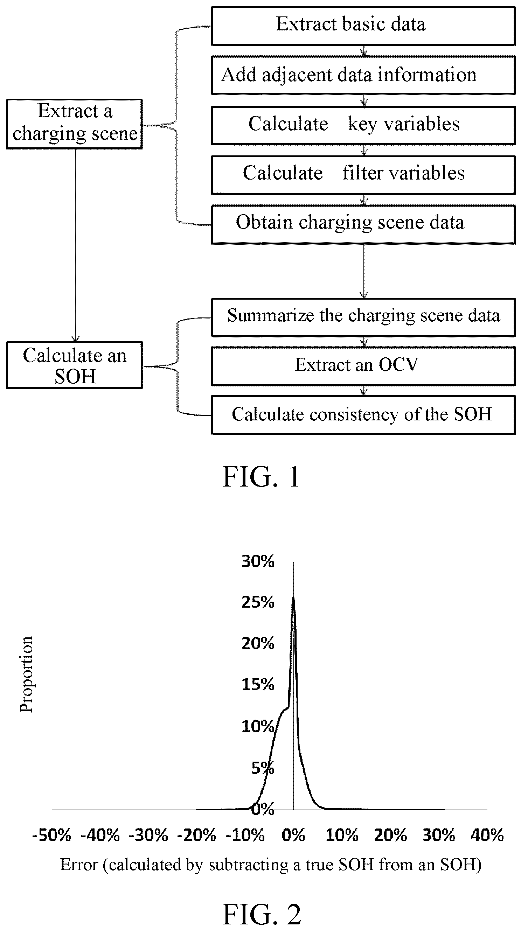

According to an embodiment of a method for calculating an SOH of a power supply system of the present invention, for an LFP power supply system, all vehicle data is stored by using a data platform Apache Hadoop, the data is calculated by using a computing platform Apache Spark, and the data is extracted and calculated by using SQL. A whole process of the method of the present invention is described below with reference to FIG. 1.

Step I: Obtain charging and discharging data of the LFP power supply system from the data platform Apache Hadoop, and extract charging scene data from the charging and discharging data.

### 1. Extract basic data.

A plurality of pieces of data of days T-1 to T-3 (T represents today, T-1 represents yesterday, and T-3 represents the day of three days ago) is extracted. Each piece of data includes a vehicle ID, a charging/discharging moment, a highest cell voltage, a lowest cell voltage, a charging/discharging current, a displayed state of charge (SOC), a temperature, positions of the temperature and a voltage (the position of cell with corresponding voltage or temperature), a rated capacity, and battery management system state information. The battery management system state information is used for representing charging and discharging states. For example, if the information is 4, it indicates that the power supply system is in a discharging state. If the information is 6, it indicates that the power supply system is in a charging state.

Data that satisfies the following conditions is screened out:① in charging state, ② a current > A (-800A < A < 800A), ③ the SOC > B (0 < B < 10%), and a temperature > C (-50°C < C < 50°C), ④ a time interval between a data storage moment and a data acquisition moment is between D and E (0s to 3600s). It is to be noted that the data storage moment herein refers to a moment the data is uploaded to the data platform Apache Hadoop herein. If the time interval between the data storage moment and the data acquisition moment is excessively long, it indicates that the data is not reliable enough. To ensure accuracy of calculation by using the method of the present invention, the data that is not reliable enough is not taken into consideration.

### 2. Add adjacent data information.

Add a previous data moment, a previous displayed data SOC, and a previous data current to each piece of data.

### 3. Calculate key variables.

1) Calculate a time interval △t: the previous data moment is subtracted from a current data moment.
2) Calculate an interval SOC △SOC: the previous displayed data SOC is subtracted from a current displayed data SOC.
3) Whether the current jumps: if an absolute value of a difference between a charging current of the current piece of data and a charging current of the previous piece of data is greater than F (F represents a set current deviation threshold, which may be set to 0A to 10A), it is defined that the current jumps; otherwise, it is defined that the current does not jump.
4) Capacity calculation: when a time interval △t between two pieces of data is less than G (G represents a set low adjacent time threshold, which may have a value set to 60s to 120s), a charging capacity between two moments corresponding to the two pieces of data is equal to the charging current multiplied by the time interval △t. When the time interval △t between the two pieces of data is greater than H (H represents a set high adjacent time threshold, which may have a value set to 120s to 240s) and an interval SOC △SOC corresponding to two adjacent pieces of data is less than I (I represents a set SOC threshold, which may have a value set to 1A to 5A), the charging capacity between two moments corresponding to the two pieces of data is equal to the charging current multiplied by 10s. In other cases, the charging capacity between the two moments corresponding to the two pieces of data is equal to an average of two charging currents multiplied by the time interval △t.
5) Calculate energy: when the time interval △t between two pieces of data is less than G (a meaning and a range of G are the same as above), charging energy between two moments corresponding to the two pieces of data is equal to the charging current multiplied by the time interval △t and then multiplied by a voltage. When the time interval △t between the two pieces of data is greater than H (a meaning and a range of H are the same as above) and an interval SOC △SOC corresponding to two adjacent pieces of data is less than I (a meaning and a range of I are the same as above), the charging energy between the two moments corresponding to the two pieces of data is equal to the charging current multiplied by 10s and then multiplied by the voltage. In other cases, the charging energy between the two moments corresponding to the two pieces of data is equal to an average of two charging currents multiplied by the time interval △t and then multiplied by the voltage.
6) Charging start label: when the interval SOC △SOC of two pieces of data is greater than J (0-5%) and the time interval is less than K (0.5h to 1.5h), or the interval SOC △SOC of the two pieces of data being less than L (0 to 5%) is defined as charging not started and is otherwise defined as charging started.
7) Grouping charging data based on the charging start label, and adding a label to a group, so that a plurality of charging groups may be determined.

### 4. Calculate filter variables.

1) Calculate a minimum time of a vehicle in each charging group, which is defined as a charging start time.
2) Calculate a maximum time of the vehicle in each charging group, which is defined as a charging end time.
3) Calculate a total number of current jumps. A current jump refers to a great difference between a charging current of a piece of data and a charging current of a previous piece of data.

### 5. Obtain charging scene data.

Retain data which occurs after the charging start time and before the charging end time, in which a number of current jumps/total number of current jumps is less than N (N representing a set jump percentage threshold, which may have a value set to 10% to 80%), and which represents a charging start time of day T-2.

The data of day T-2 is extracted from the data of days T-1 to T-3 due to a phenomenon that charging one time often spans two successive days. For example, a full charge starts at 10 p.m. one day and ends at 3 a.m. a next day. Considering this situation, to obtain all complete charging data, all charging scenes are identified without omission, to improve calculation coverage, thereby extracting complete data of day T-2 from all of the data of days T-1 to T-3.

### 6. Summarize the charging scene data.

1) Extract charging scene data of day T-2.
2) Extract a plurality of charging groups in the charging scene data of day T-2, the data of one charging group being data of one full charge, and calculate a charging start time, a charging end time, a total capacity, total energy, a total charging duration, a maximum SOC interval, a maximum time interval, a maximum current, an average current, and a highest cell voltage of each charging group of each vehicle.
3) Extract start/end information of each charging group of each vehicle: a charging start/end current, a start/end SOC, a highest (lowest) start/end temperature, a position of the highest (lowest) start/end temperature, a highest (lowest) start/end voltage, a position of the highest (lowest) start/end voltage, and a rated capacity (if a fixed information table includes the rated capacity, the rated capacity is obtained from the fixed information table, and if the fixed information table does not include the rated capacity, the rated capacity is obtained from a BMS).
4) Summarize the information of 2) and 3), and retain the charging group that satisfies the following requirements: a difference between a displayed SOC of a last piece of data of a charging group and a displayed SOC of a first piece of data is greater than O (O represents a set SOC difference threshold, which may have a value of 20% to 100%), a total charging time > P (P represents a set duration threshold, which may have a value of 10min to 30min), the displayed SOC of the last piece of data is greater than Q (Q represents a set SOC end threshold, which may have a value of 95% to 100%), a ratio of a number of current jumps during current charging to a total number of current groups of all charging groups is less than E (E represents a set jump percentage threshold, which may have a value of 0 to 20%), a difference between position sequence numbers of a cell with a highest voltage and a cell with a second highest voltage is greater than 1 (Indicates that the positions of the cell with a highest voltage and the cell with a second highest voltage are not adjacent), or the lowest cell voltage is greater than R (R represents a set low voltage threshold, which may have a value of 2.5V to 3.65V). It is to be noted that, positions of the cell with a highest voltage and the cell with a second highest voltage are adjacent positions, that is the position sequence numbers of the cell with a highest voltage and the cell with a second highest voltage is greater than 1, and the voltage of the cell with a lowest voltage is less than the set low voltage threshold, it indicates that a fluctuation occurs at a charge termination, and data corresponding to this situation is to be excluded in this case.

Step II: Obtain the charging scene data, and then calculate the SOH of the power supply system for one charging group.
1. Calculate a true SOC SOC_{high start} of the cell with a highest voltage at a start of charging during the current charging and a true SOC SOC_{low start} of the cell with a lowest voltage at a start of charging during the current charging.
   1) Extract first R (R may be in a range of 10 to 100) pieces of data before the charging is divided into groups , determine whether a charging current for the current charging is greater than or equal to a set charging current threshold A₁, if so, perform step 3) and step 4), otherwise, perform step 2).
   2) Use, based on a highest cell voltage V_{highest} and a lowest cell voltage V_{lowest} of a last piece of data in the first R pieces of data before the charging group and the set SOC-OCV relationship, an SOC corresponding to the highest cell voltage V_{highest} of the last piece of data in the first R pieces of data before the charging group as the true SOC SOC_{high start} of the cell with a highest voltage at the start of charging during the current charging, and an SOC corresponding to the lowest cell voltage V_{lowest} of the last piece of data in the first R pieces of data before the charging group as the true SOC SOC_{low start} of the cell with a lowest voltage at the start of charging during the current charging.
   3) Remove, from the first R pieces of data, a part whose current is greater than A₂ (A₂ represents a set quiescent current threshold), divide continuous data into a segment, identify a data segment having a longest time (the time needs to be greater than 2 min), use a voltage of a last piece of data in the data segment having the longest time as an OCV, and calculate the true SOC based on the SOC-OCV relationship. To be specific, a true SOC SOC_{OCV high} of a highest OCV corresponding to the highest cell voltage V_{OCV high} of the last piece of data is determined based on the highest cell voltage V_{OCV high} of the last piece of data in the charging and discharging data segment and the SOC-OCV relationship, and a true SOC SOC_{OCV low} of a lowest OCV corresponding to the lowest cell voltage V_{OCV low} of the last piece of data is determined based on the lowest cell voltage V_{OCV low} of the last piece of data in the charging and discharging data segment and the SOC-OCV relationship.
   4) Since charging and discharging occur between a moment of the last piece of data in step 3) and a charging start moment of the charging group, the SOC needs to be compensated, to obtain the true SOC SOC_{low start} of the cell with a lowest voltage at the start of charging and the true SOC SOC_{high start} of the cell with a highest voltage at the start of charging. A specific manner is: 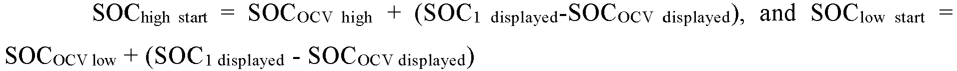 SOChigh start = SOCOCV high + (SOC1 displayed-SOCOCV displayed), and SOClow start = SOCOCV low + (SOC1 displayed - SOCOCV displayed)
      where SOC_{OCV displayed} represents a displayed SOC SOC_{OCV displayed} of the last piece of data in a charging and discharging data segment in step 3), and SOC_{1 displayed} represents a displayed SOC of a first piece of data of the charging group; A function of compensation in the step is that since charging and discharging behaviors may exist between an OCV measurement moment and the charging start time, which leads to a change in the SOC, the SOC calculated based on the OCV needs to be compensated, to ensure that the compensated SOC corresponds to a state before the charging.

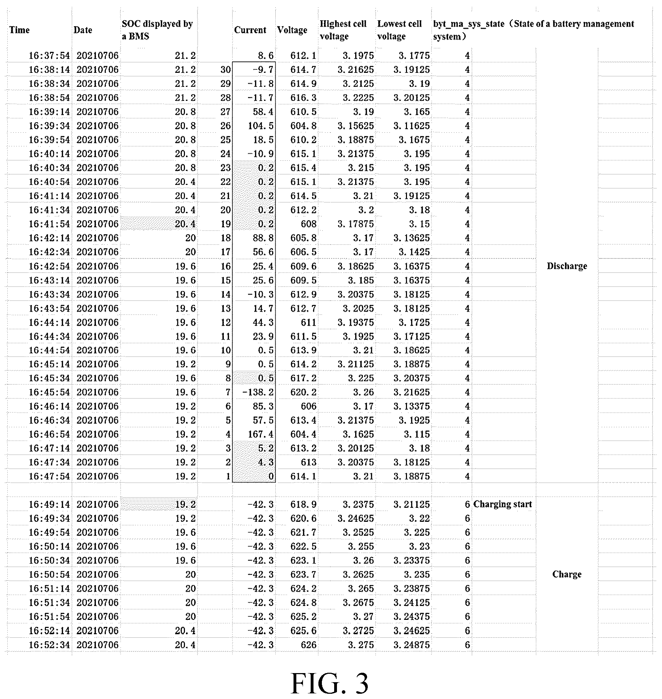

A specific example is given below to describe a specific calculation process in step 3) to step 4). For example, for the data of FIG. 3, the process is as follows: ① it may be learned based on the state of the BMS that 16:49:14 is a first piece of data at the start of charging, and 30 pieces of discharge data are extracted forward (from 16:38:14 to 16:47:54). ② Remove data having an absolute current value greater than 5A (the value being positive in the case of discharging and negative in the case of charging), and exclude all large currents herein to avoid a polarization effect. Based on continuity of the data, the remaining data is divided into three parts: 16:40:14-16:41:54, 16:45:14-16:45:34, and 16:46:54-16:47:54. For the problem herein, it is to be noted that a correct manner of calculating a total duration is subtracting a moment corresponding to a previous piece of data of the first piece of data from a moment of the last piece of data. For example, if a power-off current of a battery is 100 at 15:00:00 and a power-on current is 0 at 16:00:00, and charging is started at 16:00:20, a previous holding time is 1 hour. ③ Calculate a holding time of each segment, select a segment having the longest holding time, which is 16:40:14-16:41:54 herein, select a final highest cell voltage 3.17875 and lowest cell voltage 3.15 thereof as OCVs, and convert the voltages into the true SOC based on the SOC-OCV curve, which respectively correspond to 15% and 14% (as examples). ④ At this moment, the displayed SOC of the BMS is 20.4%, and the displayed SOC of the BMS before charging is 19.2%. Therefore, the true SOC SOC_{high start} corresponding to the cell with a highest voltage before the charging is 15% + (19.2%-20.4%), and the true SOC SOC_{low start} corresponding to the cell with a lowest voltage is 14% + (19.2%-20.4%).

2. Calculate a charging capacity C_{N} for the current charging.
1) Calculate the charging capacity Cₓ between adjacent moments corresponding to two adjacent pieces of data based on a time interval △t corresponding to the two adjacent pieces of data and the charging current. For the specific calculation manner, reference may be made to part of the contents of "4) Capacity calculation" of "3. Calculate key variables" in step I.
2) Add the charging capacities among all adjacent moments to obtain the charging capacity C_{N}=ΣC_{X} for the current charging.
3) Calculate a difference between the SOC at the start of charging and the SOC of previous piece of data before charging, which is defined as a compensation capacity and compensated into the calculated charging capacity. The purpose of the current compensation is to prevent a capacity calculation error caused by a data loss before charging.

Specifically, the data loss occurs at the start of charging in an actual process, and therefore compensation needs to be performed. To be specific, although the data is lost, this part of the charging capacity may be supplemented based on a difference between SOCs of the two pieces of data. Supplementary capacity = rated capacity*(the SOC at the start of charging - the previous SOC before charging).

When the data is normal and no data is lost, the SOC at the start of charging is equal to the previous SOC before charging. Therefore, the supplementary capacity is 0.

3. Calculate an SOH SOH_{cell} of the cell with a highest voltage: ${SOH}_{cell} = {C}_{N} / \left[\left(100%-{SOC}_{high start}\right)*{C}_{rated}\right]$
where C_{rated} represents a rated capacity of the cell with a highest voltage.

4. Calculate a consistency coefficient: ${k}_{consistency} = 100 % - {SOC}_{high start} - {SOC}_{low start}$

5. Calculate an SOH SOH_{system} of the power supply system: ${SOH}_{system} = {SOH}_{cell} * {k}_{consistency}$

6. Calculate a usage time t of a vehicle based on the SOH SOH_{system} of the power supply system: $t = \sqrt[k 1]{\left(1-SOH\right) / k 2}$
where k1 and k2 both represent usage time parameters. It may be seen from the equation that the definition of the usage time herein is not a current time minus a delivery time or a sales time. Because the inaccurate time and battery replacement cause the usage time calculated by using the method to be meaningless, and similar problems such as battery replacement and mileage reset also exist in mileages, the usage time is determined by using the SOH. Specifically, the two usage time parameters are determined in the following manners: ① obtaining a plurality of sets of different usage times and different SOH data of the power supply system, and using, as an SOH corresponding to a usage time, the corresponding SOH data that occurs a maximum number of times at the usage time. For example, an actual SOH of most vehicles is determined based on the distribution of the SOH of every 1 year or so (± 0.2) (for example, (0.988, 0.93) is obtained based on a statistical distribution, that is, in most distributions, an SOH corresponding to 0.988 years (about 1 year) is 0.93), and a most probable correspondence relationship between an actual number of years and an SOH is obtained based on the statistical data. ② Fitting the different usage times and the corresponding SOH data to the equation $t = \sqrt[k 1]{\left(1-SOH\right) / k 2}$ to obtain the usage time parameters k1 and k2. In this embodiment, k1 = 0.6484, and k2 = 0.07414.

7. Calculate a new SOC-OCV relationship based on the usage time t: $SOC = A \times {e}^{B \times OCV}$ $A = A 1 \times {e}^{A 2 \times t}$ $B = B 1 \times {e}^{B 2 \times t}$
where the SOC represents an SOC corresponding to an OCV, and A1, A2, B1, and B2 all represent aging parameters.

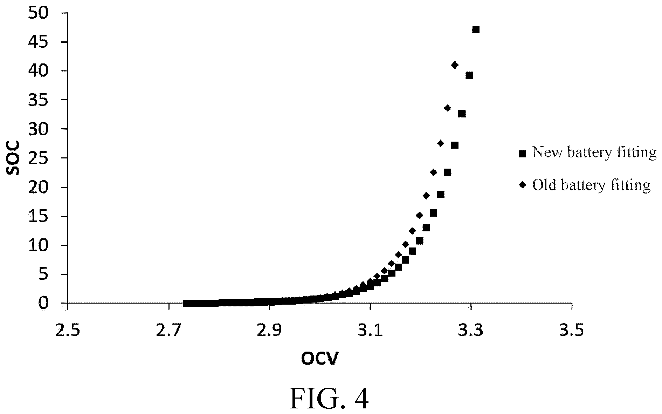

8. Re-perform step 1 to step 5 of step II after the new SOC-OCV relationship is obtained, to obtain a latest SOH SOH_{system} of the power supply system. This is because a specific difference exists between SOC-OCV relationship curves of a new battery and an old battery. As shown in FIG. 4, the SOC-OCV relationship curve changing with the usage time is used to deal with influence of battery aging on calculation accuracy in the method.

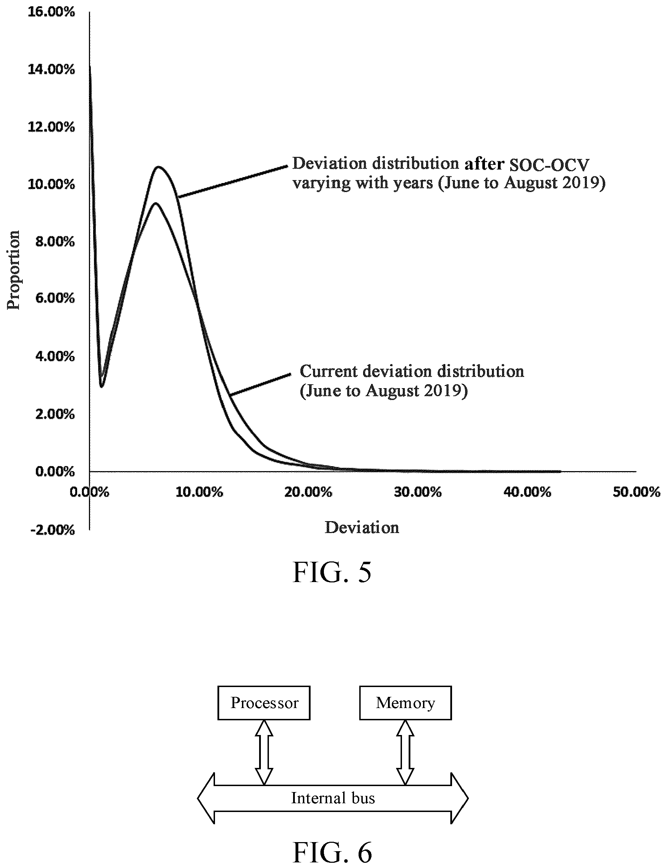

The distribution of errors of the SOH calculated by using the method of the present invention is shown in FIG. 2. A test range is greater than 40 thousand times, ±4% covers 87% of vehicles, and a weighting accuracy is 2.13% (the weighting accuracy is a sum of an absolute value of the error multiplied by a corresponding proportion). FIG. 5 is a schematic diagram of a deviation distribution after SOC-OCV curve varies with years and a current deviation distribution. The graph is based on the following assumption: in a short period of time (3 months) at an ordinary temperature, the SOH deviation calculated for the same vehicle should not be excessively large, to evaluate the overall situation of the results of the method of the present invention. A maximum SOH of each vehicle within 3 months minus a minimum SOH is defined as the SOH deviation of the vehicle. A distribution diagram of the SOH deviations drawn for all vehicles is shown in FIG. 5. After each iterative algorithm, the deviation distribution of the SOH before and after iteration is compared to determine an improvement effect of the algorithm. In addition, if the deviation distribution is closer to a y-axis, it indicates that the method has better overall quality.

Based on the above, the method has the following characteristics: 1) The charging data is extracted based on a battery status, a single charging process is identified, the key variable in the charging process is calculated, and a scene is filtered. 2) OCV data before charging is identified and extracted, which resolves the problem of identifying the OCV of the battery, and converted into the corresponding real SOC based on the SOC-OCV curve, and a loss of the SOC and a loss of charging data are compensated, thereby ensuring accuracy of calculation of the SOH. 3) Aging treatment can be performed to correct influence of aging of the SOC-OCV relationship curve on a calculated value of the SOH. 4) High-precision calculation of the SOH of the power supply system is implemented as a whole, which may be used for a core pricing model of power supply system insurance business and early warning of abnormal vehicle attenuation.

### Apparatus embodiment:

As shown in FIG. 6, an embodiment of an apparatus for calculating an SOH of a power supply system of the present invention includes a memory, a processor, and an internal bus, and communication and data interaction between the processor and the memory are completed through the internal bus. At least one software functional module is stored in the memory, and the processor executes various functional applications and data processing by running a software program and modules in the memory, thereby implementing the method for calculating an SOH of a power supply system introduced in the method embodiment of the present invention.

The processor may be a processing apparatus such as a microprocessor MCU and a programmable logic device FPGA. The memory may be various memories such as a RAM and a ROM that store information by using electric energy, or may be various memories such as a hard disk, a floppy disk, a magnetic tape, a magnetic core memory, a bubble memory, and a USB flash drive that store information by using magnetic energy, may also be various memories such as a CD and a DVD that store information by optical means, and certainly, may also be memories such as a quantum memory and a graphene memory that store information in other manners.

## Claims

1. A method for calculating a state of health, SOH, of a battery, wherein the method is carried out by an apparatus comprising a processor, a memory, and an internal bus, and wherein the method comprises the following steps:
1) obtaining a plurality of pieces of charging and discharging data corresponding to the battery at different moments, wherein each of the pieces of charging and discharging data comprises a charging/discharging moment, a displayed state of charge, SOC, a charging/discharging current, a highest cell voltage, and a lowest cell voltage, and extracting, from the charging and discharging data, charging scene data that satisfies a requirement, wherein the charging scene data comprises a plurality of charging groups, and data of one charging group is data of a full charging process;
2) performing the following calculation on the charging group:
determining a charging capacity C_{N} for current charging based on each moment and a corresponding charging current thereof;
extracting the plurality of pieces of charging and discharging data before the charging is divided into groups if the charging current for the current charging is greater than or equal to a set charging current threshold A₁, screening the charging and discharging data for a segment of charging and discharging data whose discharging current is less than a set quiescent current threshold A₂ and that has a longest duration, and determining, based on a highest cell voltage V_{OCV high}/lowest cell voltage V_{OCV low} of a last piece of data in the piece of charging and discharging data and an SOC-open circuit voltage, OCV, relationship, a true SOC SOC_{OCV high} of a highest OCV/true SOC SOC_{OCV low} of a lowest OCV corresponding to the highest cell voltage V_{OCV high}/lowest cell voltage V_{OCV low} of the last piece of data; and calculating a true SOC SOC_{high start} of a cell with a highest voltage at a start of charging during the current charging and a true SOC SOC_{low start} of a cell with a lowest voltage at the start of charging during the current charging based on the following equation: 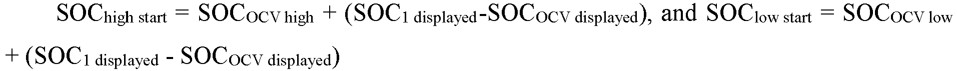 SOChigh start = SOCOCV high + (SOC1 displayed-SOCOCV displayed), and SOClow start = SOCOCV low + (SOC1 displayed - SOCOCV displayed)
wherein SOC_{OCV displayed} represents a displayed SOC SOC_{OCV displayed} of the last piece of data in the segment of charging and discharging data, and SOC_{1 displayed} represents a displayed SOC of a first piece of data of the charging group;
3) calculating an SOH SOH_{cell} of the cell with a highest voltage based on the following equation: SOH_{cell} = C_{N}/[(100%-SOC_{high start})*C_{rated}], wherein C_{rated} represents a rated capacity of the cell with a highest voltage; and
4) obtaining an SOH of the battery based on the SOH SOH_{cell} of the cell with a highest voltage,
wherein in step 4), an SOH SOH_{system} of the battery is calculated based on the following equation: SOH_{system} = SOH_{cell}*k_{consistency}, wherein k_{consistency} represents a consistency coefficient, and k = 100% - SOC_{high start} - SOC_{low start}.

2. The method for calculating an SOH of a battery according to claim 1, wherein in step 2), if the charging current for the current charging is less than the set charging current threshold A₁, an SOC corresponding to a highest cell voltage V_{highest}/lowest cell voltage V_{lowest} of the last piece of data before the charging is divided into groups is used as the true SOC SOC_{high start} of the cell with a highest voltage/true SOC SOC_{low start} of the cell with a lowest voltage at the start of charging during the current charging based on the highest cell voltage V_{highest}/lowest cell voltage V_{lowest} of the last piece of data before the charging is divided into groups and the SOC-OCV relationship.

3. The method for calculating an SOH of a battery according to claim 2, further comprising step 5) and step 6):
5) correcting the SOC-OCV relationship by using the following equations: $SOC = A \times {e}^{B \times OCV}$ $A = A 1 \times {e}^{A 2 \times t}$ $B = B 1 \times {e}^{B 2 \times t}$
wherein SOC represents an SOC corresponding to an OCV, A1, A2, B1, and B2 all represent aging parameters, and t represents a usage time; and
6) re-performing step 2) to step 4) by using the corrected SOC-OCV relationship, to obtain a corrected SOH SOH_{system} of the battery.

4. The method for calculating an SOH of a battery according to claim 3, wherein the usage time t is calculated by using the following equation: $t = \sqrt[k 1]{\left(1-SOH\right) / k 2}$ wherein k1 and k2 both represent usage time parameters, and SOH represents the SOH of the battery and is the SOH of the battery obtained in step 4).

5. The method for calculating an SOH of a battery according to claim 4, wherein the usage time parameters k1 and k2 are determined in the following manners:
obtaining a plurality of sets of different usage times and different SOH data of the battery, and using, as an SOH corresponding to a usage time, the corresponding SOH data that occurs a maximum number of times at the usage time; and
fitting the different usage times and the corresponding SOH data to the equation $t = \sqrt[k 1]{\left(1-SOH\right) / k 2}$ to obtain the usage time parameters k1 and k2.

6. The method for calculating an SOH of a battery according to claim 1, wherein in step 1), the requirement comprises at least one of following requirements:
requirement 1: a ratio of a number of current jumps of the current charging to a total number of current jumps of all charging groups is less than a set jump percentage threshold, wherein a current jump means that an absolute value of a difference between a charging current of a piece of data and a charging current of a previous piece of data of the piece of data is greater than a set current deviation threshold;
requirement 2: positions of the cell with a highest voltage and a cell with a second highest voltage are not adjacent or the lowest cell voltage is greater than a set low voltage threshold;
requirement 3: a total charging duration of one of the charging groups is greater than a set duration threshold;
requirement 4: a difference between a displayed SOC of a last piece of data of the charging group and a displayed SOC of the first piece of data is greater than a set SOC difference threshold; and
requirement 5: the displayed SOC of the last piece of data of the charging group is greater than a set SOC end threshold.

7. The method for calculating an SOH of a battery according to claim 1, wherein a means of determining the charging capacity C_{N} for the current charging in step 2) comprises: ① calculating a charging capacity Cₓ between adjacent moments corresponding to two adjacent pieces of data based on the two adjacent pieces of data; and ② adding the charging capacities among all of the adjacent moments to obtain the charging capacity C_{N} for the current charging.

8. The method for calculating an SOH of a battery according to claim 7, wherein step 1) is based on the following: if a time interval △t corresponding to the two adjacent pieces of data is less than a set low adjacent time threshold, a charging capacity between the adjacent moments corresponding to the two adjacent pieces of data is the charging current multiplied by the time interval △t; if the time interval corresponding to the two adjacent pieces of data is greater than a set high adjacent time threshold and an interval SOC △SOC corresponding to the two adjacent pieces of data is less than a set SOC threshold, the charging capacity between the adjacent moments corresponding to the two adjacent pieces of data is the charging current multiplied by 10 seconds, and the set low adjacent time threshold is less than the set high adjacent time threshold; otherwise, the charging capacity between the adjacent moments corresponding to the two adjacent pieces of data is an average of charging currents corresponding to two pieces of data multiplied by the time interval △t.

9. An apparatus for calculating a state of health, SOH, of a battery, comprising a memory and a processor, wherein the processor is configured to execute an instruction stored in the memory to carry out all the steps of the method for calculating an SOH of a battery according to any of claims 1 to 8.

## Patentansprüche

1. Verfahren zum Berechnen eines Gesundheitszustands, SOH, einer Batterie, wobei das Verfahren durch eine Vorrichtung ausgeführt wird, die einen Prozessor, einen Speicher und einen internen Bus umfasst, und wobei das Verfahren die folgenden Schritte umfasst:
1) Erhalten einer Vielzahl von Instanzen von Lade- und Entladedaten, die der Batterie zu unterschiedlichen Zeitpunkten entsprechen, wobei die Instanzen von Lade- und Entladedaten jeweils einen Lade-/Entladezeitpunkt, einen angezeigten Ladezustand, SOC, einen Lade-/Entladestrom, eine höchste Zellenspannung und eine niedrigste Zellenspannung umfassen, und Extrahieren, aus den Lade- und Entladedaten, von Ladeszenendaten, die eine Anforderung erfüllen, wobei die Ladeszenendaten eine Vielzahl von Ladegruppen umfassen und Daten einer Ladegruppe Daten eines vollständigen Ladeprozesses sind;
2) Durchführen der folgenden Berechnung an der Ladegruppe:
Bestimmen einer Ladekapazität C_{N} zum Stromladen auf Grundlage jedes Zeitpunkt und eines entsprechenden Ladestroms davon;
Extrahieren der Vielzahl von Instanzen von Lade- und Entladedaten, bevor das Laden in Gruppen unterteilt wird, wenn der Ladestrom für das Stromladen größer oder gleich einem festgelegten Ladestromschwellenwert A₁ ist, Durchmustern der Lade- und Entladedaten auf ein Segment von Lade- und Entladedaten, dessen Entladestrom kleiner als ein festgelegter Ruhestromschwellenwert A₂ ist und das eine längste Dauer aufweist, und Bestimmen, auf Grundlage einer höchsten Zellenspannung V_{OCV hoch} / einer niedrigsten Zellenspannung V_{OCV niedrig} einer letzten Instanz von Daten in der Instanz von Lade- und Entladedaten und einer Beziehung von SOC zu Leerlaufspannung, OCV, eines wahren SOC SOC_{OCV hoch} einer höchsten OCV / eines wahren SOC SOC_{OCV niedrig} einer niedrigsten OCV, welcher der höchsten Zellenspannung V_{OCV hoch} / der niedrigsten Zellenspannung V_{OCV niedrig} der letzten Instanz von Daten entspricht; und Berechnen eines wahren SOC SOC_{hoch Start} einer Zelle mit einer höchsten Spannung bei einem Ladestart während des Stromladens und eines wahren SOC SOC_{niedrig Start} einer Zelle mit einer niedrigsten Spannung bei dem Ladestart während des Stromladens auf Grundlage der folgenden Gleichung: 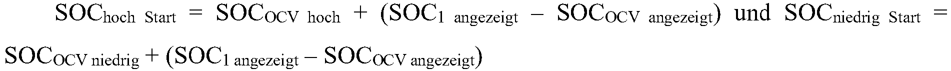 SOChoch Start = SOCOCV hoch + (SOC1 angezeigt - SOCOCV angezeigt) und SOCniedrig Start = SOCOCV niedrig + (SOC1 angezeigt - SOCOCV angezeigt)
wobei SOC_{OCV angezeigt} einen angezeigten SOC SOC_{OCV angezeigt} der letzten Instanz von Daten in dem Segment von Lade- und Entladedaten wiedergibt und SOC_{1 angezeigt} einen angezeigten SOC einer ersten Instanz von Daten der Ladegruppe wiedergibt;
3) Berechnen eines SOH SOH_{Zelle} der Zelle mit einer höchsten Spannung auf Grundlage der folgenden Gleichung: SOH_{Zelle} = C_{N} / [(100 % - SOC_{hoch Start}) * C_{Nenn}], wobei C_{Nenn} eine Nennkapazität der Zelle mit einer höchsten Spannung wiedergibt; und
4) Erhalten eines SOH der Batterie auf Grundlage des SOH SOH_{Zelle} der Zelle mit einer höchsten Spannung,
wobei in Schritt 4) ein SOH SOH_{System} der Batterie auf Grundlage der folgenden Gleichung berechnet wird: SOH_{System} = SOH_{Zelle} * k_{Konsistenz}, wobei k_{Konsistenz} einen Konsistenzkoeffizienten wiedergibt und k = 100 % - SOC_{hoch Start} - SOC_{niedrig Start}.

2. Verfahren zum Berechnen eines SOH einer Batterie nach Anspruch 1, wobei in Schritt 2), wenn der Ladestrom für das Stromladen kleiner als der festgelegte Ladestromschwellenwert A₁ ist, ein SOC, der einer höchsten Zellenspannung V_{höchste} / einer niedrigsten Zellenspannung V_{niedrigste} der letzten Instanz von Daten entspricht, bevor das Laden in Gruppen unterteilt wird, als der wahre SOC SOC_{hoch Start} der Zelle mit einer höchsten Spannung / der wahre SOC SOC_{niedrig Start} der Zelle mit einer niedrigsten Spannung bei dem Ladestart während des Stromladens auf Grundlage der höchsten Zellenspannung V_{höchste} / der niedrigsten Zellenspannung V_{niedrigste} der letzten Instanz von Daten, bevor das Laden in Gruppen unterteilt wird, und der SOC-OCV-Beziehung verwendet wird.

3. Verfahren zum Berechnen eines SOH einer Batterie nach Anspruch 2, ferner umfassend Schritt 5) und Schritt 6):
5) Korrigieren der SOC-OCV-Beziehung unter Verwendung der folgenden Gleichungen: $SOC = A \times {e}^{B \times OCV}$ $A = A 1 \times {e}^{A 2 \times t}$ $B = B 1 \times {e}^{B 2 \times t}$
wobei SOC einen SOC wiedergibt, der einer OCV entspricht, A1, A2, B1 und B2 allesamt Alterungsparameter wiedergeben und t eine Nutzungszeit wiedergibt; und
6) erneutes Durchführen von Schritt 2) bis Schritt 4) unter Verwendung der korrigierten SOC-OCV-Beziehung, um einen korrigierten SOH SOH_{system} der Batterie zu erhalten.

4. Verfahren zum Berechnen eines SOH einer Batterie nach Anspruch 3, wobei die Nutzungszeit t unter Verwendung der folgenden Gleichung berechnet wird: $t = \sqrt[k 1]{\left(1-SOH\right) / k 2}$ wobei k1 und k2 jeweils Nutzungszeitparameter wiedergeben und SOH den SOH der Batterie wiedergibt und der in Schritt 4) erhaltene SOH der Batterie ist.

5. Verfahren zum Berechnen eines SOH einer Batterie nach Anspruch 4, wobei die Nutzungszeitparameter k1 und k2 wie folgt bestimmt werden:
Erhalten einer Vielzahl von Sätzen von unterschiedlichen Nutzungszeiten und unterschiedlichen SOH-Daten der Batterie und Verwenden, als ein SOH, der einer Nutzungszeit entspricht, der entsprechenden SOH-Daten, die mit einer maximalen Häufigkeit bei der Nutzungszeit auftreten; und
Anpassen der unterschiedlichen Nutzungszeiten und der entsprechenden SOH-Daten an die Gleichung $t = \sqrt[k 1]{\left(1-SOH\right) / k 2}$, um die Nutzungszeitparameter k1 und k2 zu erhalten.

6. Verfahren zum Berechnen eines SOH einer Batterie nach Anspruch 1, wobei die Anforderung in Schritt 1) mindestens eine der folgenden Anforderungen umfasst:
Anforderung 1: ein Verhältnis einer Anzahl von Stromsprüngen bei dem Stromladen zu einer Gesamtanzahl von Stromsprüngen sämtlicher Ladegruppen ist kleiner als ein festgelegter prozentualer Sprungschwellenwert, wobei mit einem Stromsprung gemeint ist, dass ein Absolutwert einer Differenz zwischen einem Ladestrom einer Instanz von Daten und einem Ladestrom einer vorherigen Instanz von Daten der Instanz von Daten größer als ein festgelegter Stromabweichungsschwellenwert ist;
Anforderung 2: Positionen der Zelle mit einer höchsten Spannung und einer Zelle mit einer zweithöchsten Spannung grenzen nicht aneinander an oder die niedrigste Zellenspannung ist größer als ein festgelegter Schwellenwert für die niedrige Spannung;
Anforderung 3: eine Gesamtladedauer einer der Ladegruppen ist größer als ein festgelegter Dauerschwellenwert;
Anforderung 4: eine Differenz zwischen einem angezeigten SOC einer letzten Instanz von Daten der Ladegruppe und einem angezeigten SOC der ersten Instanz von Daten ist größer als ein festgelegter SOC-Differenzschwellenwert; und
Anforderung 5: der angezeigte SOC der letzten Instanz von Daten der Ladegruppe ist größer als ein festgelegter SOC-Endschwellenwert.

7. Verfahren zum Berechnen eines SOH einer Batterie nach Anspruch 1, wobei ein Mittel zum Bestimmen der Ladekapazität C_{N} für das Stromladen in Schritt 2) Folgendes umfasst: ① Berechnen einer Ladekapazität Cₓ zwischen aneinandergrenzenden Zeitpunkten, die zwei aneinandergrenzenden Instanzen von Daten entsprechen, auf Grundlage der zwei aneinandergrenzenden Instanzen von Daten; und ② Hinzufügen der Ladekapazitäten unter sämtlichen der aneinandergrenzenden Zeitpunkte, um die Ladekapazität C_{N} für das Stromladen zu erhalten.

8. Verfahren zum Berechnen eines SOH einer Batterie nach Anspruch 7, wobei Schritt 1) auf Folgendem beruht: wenn ein Zeitintervall △t, das den zwei aneinandergrenzenden Instanzen von Daten entspricht, kleiner als ein festgelegter niedriger Schwellenwert für aneinandergrenzende Zeitpunkte ist, ist eine Ladekapazität zwischen den aneinandergrenzenden Zeitpunkten, die den zwei aneinandergrenzenden Instanzen von Daten entsprechen, der mit dem Zeitintervall △t multiplizierte Ladestrom; wenn das Zeitintervall, das den zwei aneinandergrenzenden Instanzen von Daten entspricht, größer als ein festgelegter hoher Schwellenwert für aneinandergrenzende Zeitpunkte ist und ein Intervall-SOC △SOC, der den zwei aneinandergrenzenden Instanzen von Daten entspricht, kleiner als ein festgelegter SOC-Schwellenwert ist, ist die Ladekapazität zwischen den aneinandergrenzenden Zeitpunkten, die den zwei aneinandergrenzenden Instanzen von Daten entsprechen, der mit 10 Sekunden multiplizierte Ladestrom und ist der festgelegte niedrige Schwellenwert für aneinandergrenzende Zeitpunkte kleiner als der festgelegte hohe Schwellenwert für aneinandergrenzende Zeitpunkte; andernfalls ist die Ladekapazität zwischen den aneinandergrenzenden Zeitpunkten, die den zwei aneinandergrenzenden Instanzen von Daten entsprechen, ein Durchschnitt von Ladeströmen, die zwei mit dem Zeitintervall △t multiplizierten Instanzen von Daten entsprechen.

9. Vorrichtung zum Berechnen eines Gesundheitszustands, SOH, einer Batterie, umfassend einen Speicher und einen Prozessor, wobei der Prozessor dazu ausgelegt ist, eine in dem Speicher gespeicherte Anweisung auszuführen, um sämtliche der Schritte des Verfahrens zum Berechnen eines SOH einer Batterie nach einem der Ansprüche 1 bis 8 auszuführen.

## Revendications

1. Procédé permettant de calculer l'état de santé, SOH, d'une batterie, dans lequel le procédé est mis en œuvre par un appareil comprenant un processeur, une mémoire et un bus interne, et dans lequel le procédé comprend les étapes suivantes :
1) obtenir une pluralité de données de charge et de décharge correspondant à la batterie à des instants différents, dans lequel chacune des données de charge et de décharge comprend un instant de charge/décharge, un état de charge affiché, SOC, un courant de charge/décharge, une tension de cellule maximale et une tension de cellule minimale, et extraire, à partir des données de charge et de décharge, des données de scène de charge qui satisfont à une exigence, dans lequel les données de scène de charge comprennent une pluralité de groupes de charge, et les données d'un groupe de charge sont des données d'un processus de charge complète ;
2) réaliser le calcul suivant sur le groupe de charge :
déterminer une capacité de charge C_{N} pour la charge en courant à partir de chaque instant et d'un courant de charge correspondant à celui-ci ;
extraire la pluralité de données de charge et de décharge avant de diviser la charge en groupes si le courant de charge pour la charge en courant est supérieur ou égal à un seuil de courant de charge A₁ établi, filtrer les données de charge et de décharge pour un segment de données de charge et de décharge dont le courant de décharge est inférieur à un seuil de courant de repos A₂ établi et qui a une durée la plus longue, et déterminer, à partir d'une tension de cellule maximale V_{OCV haute}/tension de cellule minimale V_{OCV basse} d'une dernière donnée dans la donnée de charge et de décharge et d'une relation entre le SOC et la tension de circuit ouvert, OCV, un vrai SOC SOC_{OCV haute} d'une plus haute OCV/vrai SOC SOC_{OCV basse} d'une plus basse OCV correspondant à la tension de cellule maximale V_{OCV haute}/tension de cellule minimale V_{OCV basse} de la dernière donnée ; et calculer un vrai SOC SOC_{haut début} d'une cellule avec une tension maximale en début de charge pendant la charge en courant et un vrai SOC SOC_{bas début} d'une cellule avec une tension minimale en début de charge pendant la charge en courant à partir de l'équation suivante : 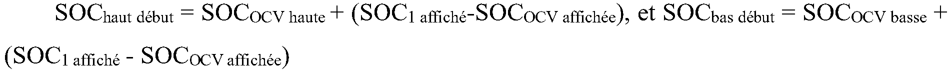 SOChaut début = SOCOCV haute + (SOC1 affiché-SOCOCV affichée), et SOCbas début = SOCOCV basse + (SOC1 affiché - SOCOCV affichée)
dans lequel SOC_{OCV affichée} représente un SOC SOC_{OCV affichée} affiché de la dernière donnée du segment de données de charge et de décharge, et SOC_{1 affiché} représente un SOC affiché d'une première donnée du groupe de charge ;
3) calculer un SOH SOH_{cellule} de la cellule avec une tension maximale à partir de l'équation suivante : SOH_{cellule} = C_{N}/[(100%-SOC_{haut début})*C_{assignée}], où C_{assignée} représente une capacité assignée de la cellule avec une tension maximale ; et
4) obtenir un SOH de la batterie à partir du SOH SOH_{cellule} de la cellule avec une tension maximale,
dans lequel à l'étape 4), un SOH SOH_{système} de la batterie est calculé à partir de l'équation suivante : SOH_{système} = SOH_{cellule}*k_{cohérence}, où k_{cohérence} représente un coefficient de cohérence, et k = 100% - SOC_{haut début} - SOC_{bas début}.

2. Procédé permettant de calculer le SOH d'une batterie selon la revendication 1, dans lequel à l'étape 2), si le courant de charge pour la charge en courant est inférieur au seuil de courant de charge A₁ établi, un SOC correspondant à une tension de cellule maximale Vₘₐₓ/tension de cellule minimale Vₘᵢₙ de la dernière donnée avant de diviser la charge en groupes est utilisé comme vrai SOC SOC_{haut début} de la cellule avec une tension maximale/vrai SOC_{bas début} de la cellule avec une tension minimale en début de charge pendant la charge en courant à partir de la tension de cellule maximale Vₘₐₓ/tension de cellule minimale Vₘᵢₙ de la dernière donnée avant de diviser la charge en groupes et la relation SOC-OCV.

3. Procédé permettant de calculer le SOH d'une batterie selon la revendication 2, comprenant en outre l'étape 5) et l'étape 6) :
5) corriger la relation SOC-OCV en utilisant les équations suivantes : $SOC = A \times {e}^{B \times OCV}$ $A = A 1 \times {e}^{A 2 \times t}$ $B = B 1 \times {e}^{B 2 \times t}$
où SOC représente un SOC correspondant à une OCV, A1, A2, B1 et B2 représentent tous des paramètres de vieillissement, et t représente un temps d'utilisation ; et
6) réaliser à nouveau l'étape 2) à l'étape 4) en utilisant la relation SOC-OCV corrigée, pour obtenir un SOH SOH_{système} corrigé de la batterie.

4. Procédé permettant de calculer le SOH d'une batterie selon la revendication 3, dans lequel le temps d'utilisation t est calculé en utilisant l'équation suivante : $t = \sqrt[k 1]{\left(1-SOH\right) / k 2}$ où k1 et k2 représentent tous deux des paramètres de temps d'utilisation, et SOH représente le SOH de la batterie et est le SOH de la batterie obtenue à l'étape 4).

5. Procédé permettant de calculer le SOH d'une batterie selon la revendication 4, dans lequel les paramètres de temps d'utilisation k1 et k2 sont déterminés de la manière suivante :
obtenir une pluralité d'ensembles de temps d'utilisation différents et de données SOH différentes de la batterie, et utiliser, comme SOH correspondant à un temps d'utilisation, les données SOH correspondantes qui se produisent un nombre maximal de fois au temps d'utilisation ; et
ajuster les différents temps d'utilisation et les données SOH correspondantes à l'équation $t = \sqrt[k 1]{\left(1-SOH\right) / k 2}$ pour obtenir les paramètres de temps d'utilisation k1 et k2.

6. Procédé permettant de calculer le SOH d'une batterie selon la revendication 1, dans lequel à l'étape 1), l'exigence comprend au moins l'une des exigences suivantes :
exigence 1 : un rapport d'un nombre de sauts de courant de la charge en courant sur un nombre total de sauts de courant de tous les groupes de charge est inférieur à un seuil de pourcentage de saut établi, un saut de courant signifiant qu'une valeur absolue d'une différence entre un courant de charge d'une donnée et un courant de charge d'une donnée précédente de la donnée est supérieure à un seuil d'écart de courant établi ;
exigence 2 : les positions de la cellule avec une tension maximale et d'une cellule avec une deuxième tension la plus élevée ne sont pas adjacentes ou la tension de cellule minimale est supérieure à un seuil de tension basse établi ;
exigence 3 : une durée totale de charge de l'un des groupes de charge est supérieure à un seuil de durée établi ;
exigence 4 : une différence entre un SOC affiché d'une dernière donnée du groupe de charge et un SOC affiché de la première donnée est supérieure à un seuil de différence SOC établi ; et
exigence 5 : le SOC affiché de la dernière donnée du groupe de charge est supérieur à un seuil de fin de SOC établi.

7. Procédé permettant de calculer le SOH d'une batterie selon la revendication 1, dans lequel un moyen de détermination de la capacité de charge C_{N} pour la charge en courant à l'étape 2) comprend : ① le calcul d'une capacité de charge Cₓ entre instants adjacents correspondant à deux données adjacentes à partir des deux données adjacentes ; et ② l'addition des capacités de charge parmi tous les instants adjacents pour obtenir la capacité de charge C_{N} pour la charge en courant.

8. Procédé permettant de calculer le SOH d'une batterie selon la revendication 7, dans lequel l'étape 1) est basée sur ce qui suit : si un intervalle de temps △t correspondant aux deux données adjacentes est inférieur à un seuil de temps adjacent bas établi, une capacité de charge entre les instants adjacents correspondant aux deux données adjacentes est le courant de charge multiplié par l'intervalle de temps △t ; si l'intervalle de temps correspondant aux deux données adjacentes est supérieur à un seuil de temps adjacent haut établi et un intervalle SOC △SOC correspondant aux deux données adjacentes est inférieur à un seuil SOC établi, la capacité de charge entre les instants adjacents correspondant aux deux données adjacentes est le courant de charge multiplié par 10 secondes, et le seuil de temps adjacent bas établi est inférieur au seuil de temps adjacent haut établi ; sinon, la capacité de charge entre les instants adjacents correspondant aux deux données adjacentes est une moyenne des courants de charge correspondant à deux données multipliée par l'intervalle de temps △t.

9. Appareil permettant de calculer l'état de santé, SOH, d'une batterie, comprenant une mémoire et un processeur, dans lequel le processeur est configuré de manière à exécuter une instruction stockée dans la mémoire pour mettre en œuvre toutes les étapes du procédé permettant de calculer le SOH d'une batterie selon l'une des revendications 1 à 8.
